# EUROPÄISCHE PATENTANMELDUNG

(11) **EP 0 628 999 A1**
(43) Veröffentlichungstag der Anmeldung: **14.12.1994**
(21) Anmeldenummer: 94201489.5
(22) Anmeldetag: 26.05.1994
(51) Int. Cl.: H01L 23/538, H01L 23/498

(54) **Verschlossene Durchkontaktierung für ein Keramiksubstrat einer Dickschichtschaltung und ein Verfahren zur Herstellung derselben**

(30) Priorität: 02.06.1993 DE 4318339
(71) Anmelder: Philips Patentverwaltung GmbH, 22335 Hamburg (DE); PHILIPS ELECTRONICS N.V., 5621 BA Eindhoven (NL)
(72) Erfinder: Drüeke, Klaus Robert, D-20097 Hamburg (DE); Wilhelm, Peter, D-20097 Hamburg (DE)
(74) Vertreter: Walz, Erich

(57) **Zusammenfassung**

Verschlossene Durchkontaktierung für ein Keramiksubstrat (11) einer Dickschichtschaltung mit einer Durchgangsöffnung (14), deren innere Mantelfläche (15) mit einer leitenden Schicht (16) versehen ist, welche mit Leiterbahnen auf beiden Flächen (12, 13) des Keramiksubstrats (11) verbunden ist und deren eine Öffnung mit einer anorganischen Schicht (17, 18) verschlossen ist, wobei die verschließende anorganische Schicht mindestens aus einer an der leitenden Schicht (16) angrenzenden und zum Keramiksubstrat überlappenden Trägerschicht (17) und einer Dichtungsschicht (18) besteht sowie ein Verfahren zu dessen Herstellung.

## Beschreibung

Die vorliegende Erfindung betrifft eine verschlossene Durchkontaktierung für ein Keramiksubstrat einer Dickschichtschaltung mit einer Durchgangsöffnung, deren innere Mantelfläche mit einer leitenden Schicht versehen ist, welche mit Leiterbahnen auf beiden Flächen des Keramiksubstrats verbunden ist und deren eine Öffnung mit einer anorganischen Schicht verschlossen ist, sowie ein Verfahren zur Herstellung der verschlossenen Durchkontaktierung.

Die Erfindung betrifft also Durchkontaktierungen von Dickschichtschaltungen an sich und hinsichtlich deren Herstellung die Verarbeitung von Dickschichtpasten durch Siebdrucken und Einbrennen.

Die Herstellung von Durchkontaktierungen in Dickschichtschaltungen ist grundsätzlich beispielsweise aus der Veröffentlichung von M. Bergmann mit dem Titel "Thickfilm or: Using Metallized Through Holes, Multilayer Structures, And Surface Mounting Components For Highest Packing Density-A Study", Proceedings of the 4th European Hybrid Microelectronics Conference, pp. 60-67, 1983, Copenhagen, bekannt. Darin wird beschrieben, daß eine Leiterbahnpaste durch Löcher hindurchgesaugt wird. Die Leiterbahnpaste verteilt sich dann über die innere Lochwandung bzw. Mantelfläche der Durchgangsöffnung. Beim anschließenden Einbrennen verbindet sich die Leiterbahnpaste mit der Keramik und stellt somit einen elektrischen Kontakt beider Substratseiten her. Ein Verschließen der Löcher bzw. Durchgangsöffnungen ist dieser Veröffentlichung nicht zu entnehmen.

In der US-PS 4.626.805 wird ein Mikrowellen-IC-Gehäuse beschrieben, bei dem die Durchkontaktierungen eines Keramiksubstrats durch den Metallisierungsvorgang der Löcher allein nicht dicht verschlossen werden können. Deshalb wird ein geätztes Metallblech auf das metallisierte Keramiksubstrat durch Hartlöten befestigt. Erst danach sind die Durchkontaktierungen hermetisch verschlossen. Nachteilig ist bei dieser Methode, daß das Hartlöten der Durchkontaktierungen überhaupt möglich sein muß, ferner erfordert das Hartlöten ein aufwendiges zusätzliches Verfahren und es ist ein zusätzliches Metallblech zum Abdecken nötig sowie der zum Löten erforderliche Flächenbedarf. Er ist größer als die Fläche der Durchkontaktierung selbst.

Aus dem Abstract der JP-A-3-201464 ist es bekannt, eine durchkontaktierte Durchgangsöffnung eines Keramiksubstrats mit einer keramischen Schicht durch Siebdruck luftdicht zu verschließen. Die keramische Schicht ist bei dieser Anordnung einschichtig und als Isolator ausgebildet. Hierbei besteht jedoch die Gefahr, daß eine offene Porösität entsteht, wenn das Dielektrikumsmaterial also die Dichtungsschicht angehäuft wird und bei einer Materialansammlung in der Durchgangsöffnung eine starke Bindung zwischen Leiterbahn- und Dielektrikumsmaterial entsteht, was dazu führen kann, daß das Leiterbahnmaterial, also die leitende Schicht sich von der Mantelfläche der Durchgangsöffnung löst.

Der vorliegenden Erfindung liegt die Aufgabe zugrunde, eine verschlossene Durchkontaktierung für Dickschichtschaltungen und ein Verfahren zur Herstellung derselben anzugeben, die einfach aufgebaut und somit einfach und sicher gegenüber materialbedingten Fehlerquellen herstellbar ist.

Diese Aufgabe wird hinsichtlich der verschlossenen Durchkontaktierung dadurch gelöst, daß die verschließende anorganische Schicht mindestens aus einer an der leitenden Schicht angrenzenden und zum Keramiksubstrat überlappenden Trägerschicht und einer Dichtungsschicht besteht, und hinsichtlich des Verfahrens zur Herstellung der verschlossenen Durchkontaktierung dadurch, daß nacheinander
- in das Keramiksubstrat (11) eine Durchgangsöffnung (14) eingebracht wird,
- deren innere Mantelfäche mit einer leitenden Schicht bedruckt und eine oder beide Flächen des Keramiksubstrats bedruckt werden,
- auf der zu verschließenden Fläche der Durchgangsöffnung eine die Ränder der Durchgangsöffnung überlappende Fläche mit einer Trägerschicht bedruckt und anschließend der Gegenstand getrocknet und gebrannt wird,
- wobei die bedruckte Fläche des Keramiksubstrats während des Trocknens und Brennens nach unten gerichtet wird, und
- zum Verschließen der Leckstellen der Trägerschicht darauf mindestens eine Dichtungsschicht durch Drucken, Trocknen und Brennen aufgebracht wird.

Vor der Beschichtung eines Keramiksubstrats für eine Dickschichtschaltung werden Löcher in das keramische Basismaterial beispielsweise mit einem Laser gebohrt. Bei Keramiksubstraten mit einer Materialdicke von weniger als 1 mm wird in der Regel ein Durchmesser von einigen Zehntelmillimetern gewählt. Die elektrische Funktion der Durchkontaktierung wird dadurch hergestellt, daß eine dünne und ganzflächige leitende Schicht mit guter Haftfestigkeit auf der Mantelfäche der Durchgangsöffnung erzeugt wird. Die Durchkontaktierungen werden dazu mit einer Silberpalladium-Leiterbahnpaste gedruckt. Vorteilhaft können gleichzeitig auch Leiterbahnen in diesem Bearbeitungsschritt hergestellt werden. Dabei wird ein Siebdruckprozeß entweder nur von einer Seite ausgeführt oder von beiden Seiten. Die Auswahl hängt von der Siebdruckeinrichtung selbst ab.

Leiterbahnpasten haben generell eine poröse Mikrostruktur und sind deswegen zum hermetischen vollständigen Verschließen der Durchgangsöffnung an sich nicht geeignet. Beim erfindungsgemäßen Verfahren wird vorteilhaft bereits das Leiterbahnmaterial verwandt, um den Lochquerschnitt zu verringern bzw. eine Trägerschicht für die nachfolgende Beschichtung mit einem Dielektrikumsmaterial also einer Dichtungsschicht zu bilden. Dazu wird mit der Silberpalladium-Paste eine Trägerschicht über das durchkontaktierte Loch gedruckt. Beim Trocknen und Brennen dieser Trägerschicht wird die bedruckte Seite nach unten gelegt, damit das Material nicht in die Durchgangsöffnung sinkt. Gleichzeitig können Leiterbahnen zusammen mit der Abdeckung oder in einem getrennten Bearbeitungsschritt auf das Keramiksubstrat gedruckt werden.

Das eigentliche hermetische Verschließen der Durchgangsöffnungen erfolgt durch das Bedrucken der Durchgangsöffnungen bzw. auch deren Ränder mit der Dielektrikumspaste, die als Dichtungsschicht wirkt. Um Leckstellen in dieser Dichtungsschicht zu schließen, kann eine zweite Dielektrikumsschicht erzeugt werden. Die Eigenschaften des Dielektrikumsmaterials bzw. der Dichtungsschicht entsprechen vorteilhaft den nachfolgenden Anforderungen. Die Viskosität bei einer Sintertemperatur von etwas unterhalb 1000°C muß niedrig genug sein, so daß das Material gut fließt und das Leiterbahnmaterial, also die Trägerschicht durchdringt. Für die Abdeckung der Durchgangsöffnung ist vorteilhaft der thermische Ausdehnungskoeffizient der Schichtmaterialien aneinander anzupassen. Ist dieser zu hoch, dann können Risse im Dielektrikumsmaterial beim Abkühlen entstehen. Dementsprechend kann nicht jedes Dickschichtmaterial als Dichtungsschicht verwendet werden. Es darf auch aus zwei Gründen nicht in das Loch fließen. Einerseits bleibt eine offene Porösität, wenn das Dielektrikumsmaterial angehäuft wird. Andererseits hat das Leiterbahnmaterial eine höhere Affinität zum Dielektrikumsmaterial als zum Keramiksubstrat. Bei einer Materialansammlung in der Durchgangsöffnung entsteht eine starke Bindung zwischen Leiterbahn- und Dielektrikumsmaterial, so daß sich das Leiterbahnmaterial von der Mantelfläche der Durchgangsöffnung lösen kann, was erfindungsgemäß durch die Trägerschicht in einfacher und vorteilhafter Weise vermieden wird.

Weitere vorteilhafte Ausgestaltungen der Erfindung sowohl hinsichtlich der verschlossenen Durchkontaktierung selbst als auch des Verfahrens zu dessen Herstellung ergeben sich aus den jeweiligen Unteransprüchen.

Ein Ausführungsbeispiel der Erfindung wird nachfolgend unter Bezugnahme auf eine Zeichnung näher erläutert. Darin zeigt:
- Fig. 1: eine erfindungsgemäße hermetisch vollständig abgeschlossene Durchkontaktierung eines gebrochen dargestellten Keramiksubstrats einer Dickschichtschaltung,
- Fig. 2: eine noch nicht verschlossene, wohl aber bereits beschichtete Durchkontaktierung entsprechend Fig. 1., und
- Fig. 3: eine mit einer Trägerschicht versehene Durchkontaktierung entsprechend Fig. 2.

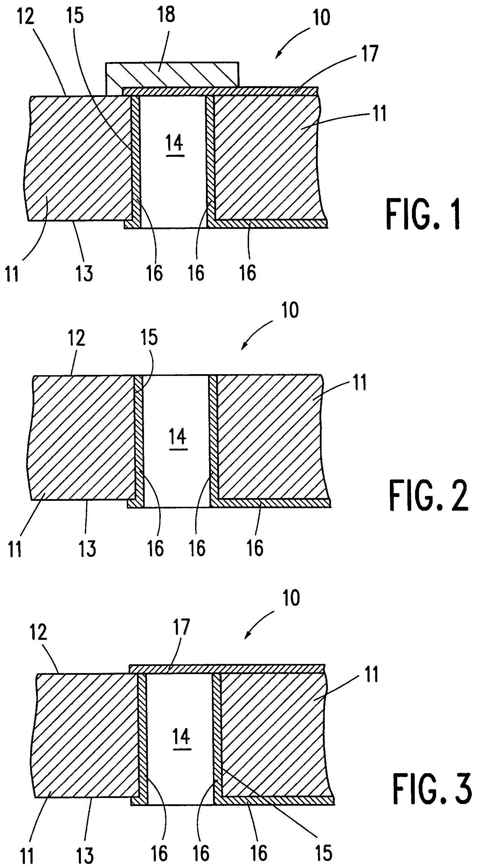

Fig. 1 zeigt eine erfindungsgemäße Durchkontaktierung 10 durch ein keramisches Basismaterial bzw. ein Keramiksubstrat 11 hindurch, auf dem nicht dargestellte Dickschichtschaltungen hergestellt werden, bei denen beide Seiten des Keramiksubstrats 11 bzw. der Schaltung unterschiedlich bestückt werden können.

Die in den Fig. oberen und unteren Flächen 12, 13 des Keramiksubstrats 11 werden für nicht dargestellte Leiterbahnen, integrierte Widerstände und Bauteile verwandt, so daß eine hohe Packungsdichte erreicht werden kann. Bei der Bestückung einer Seite durch nicht dargestellte Chips, beispielsweise der ersten oberen Fläche 12, werden diese durch hermetisch verschlossene erfindungsgemäße Durchkontaktierungen 10 und beispielsweise durch eine nicht dargestellte montierte Kappe vor atmosphärischen, also Umgebungseinflüssen, wie Korrosion etc., geschützt, wodurch eine hohe Lebensdauer bzw. Zuverlässigkeit möglich wird. Die erfindungsgemäß verschlossenen Schaltungen erfüllen die Beurteilungskriterien beispielsweise des Umweltprüfverfahrens nach DIN IEC 68, Teil 2 bis 17 wie auch den entsprechenden Lecktest nach MIL-STD-883 C, Method 10 14 7. Die zweite, untere Fläche 13 des Keramiksubstrats 11 kann einen entsprechenden Schaltungsaufbau für nicht dargestellte Widerstände, zusätzlich montierte Bauelemente und Kühlkörper aufnehmen. Die Schaltungen können zusammen mit einem Lötkamm auf die Leiterplatten gebracht werden.

Das in Fig. 1 dargestellte Keramiksubstrat 11 weist dazu eine Durchgangsöffnung 14 auf, die als Durchgangsbohrung ausgestattet ist, deren innere Mantelfläche 15 und deren in den Fig. untere Fläche 13 mit einer leitenden Schicht 16 versehen ist. Die leitende Schicht 16 ist vorteilhaft eine Silberpalladium-Dickschichtpaste. Zum Verschließen der Durchgangsöffnung 14 auf der in den Fig. oberen Fläche 12 des Keramiksubstrats 11 ist dort zunächst eine leitende Trägerschicht 17 angeordnet. Die Trägerschicht 17 kann mittels Siebdruckverfahren aufgebracht sein und besteht vorteilhaft aus einer Silberpalladium-Dickschichtpaste. Die Trägerschicht 17 ist zur vollständigen hermetischen Abdichtung der Durchgangsöffnung 14 mit mindestens einer dichtenden Dichtungsschicht 18 im Bereich der Durchgangsöffnung und diesen leicht überlappend verschlossen. Die Dichtungsschicht 18 besteht vorzugsweise aus einer Dielektrikum-Dickschichtpaste. Zur sicheren Abdichtung oder zur Aufnahme voneinander zu isolierender Leiterbahnen können auch mehrere Dichtungsschichten 18 übereinander angeordnet sein. Die leitende Schicht 16, die Trägerschicht 17 und die Dichtungsschicht 18 wurden wie üblich getrocknet und gebrannt, um mit dem Keramiksubstrat 11 eine leitende und gute Verbindung herzustellen.

Die Fig. 1, 2 und 3 zeigen verschiedene Herstellungsstufen, die beim erfindungsgemäßen Herstellungsverfahren zur Durchkontaktierung 10 gem. Fig. 3 führen. Das Verfahren zur Herstellung wird nachstehend anhand der Fig. näher erläutert werden.

Fig. 2 zeigt das Keramiksubstrat 11, das beispielsweise eine Materialdicke von 0,635 mm aufweist, in das beispielsweise mit einem Laser Durchgangsöffnungen 14 mit einem Durchmesser von beispielsweise 0,15 mm eingebracht werden. Bei einem ersten Siebdruck- und Einbrennvorgang werden mit einer Silberpalladium-Leiterbahnpaste die leitenden Schichten 16 auf der Mantelfläche 15 der Durchgangsöffnung 14 und auf der unteren Seite 13 des Keramiksubstrats 11 erzeugt.

Fig. 3 zeigt den hieran anschließenden Verfahrensschritt. Auf der oberen Fläche 12 des Keramiksubstrats 11 wird die Trägerschicht 17, eine Silberpalladium-Leiterbahnpaste, über die zu schließende Durchgangsöffnung 14 gedruckt. Bei diesem Druckvorgang können gleichzeitig nicht dargestellte Leiterbahnen gedruckt werden. Nach dem Trocknen und Brennen entsteht eine Art Brücke, die als Stütze für die folgende Beschichtung dient. Weder die Leiterbahn- noch die Dielektrikumspasten dürfen in die Durchgangsöffnung 14 fließen, da sich dann eine Materialansammlung bilden könnte, wodurch eine Porenbildung stattfinden würde, die ein Verschließen der Durchgangsöffnung 14 nicht mehr zuließe. Es können in diesem Zustand nun weitere Leiterbahnen wie üblich auf beiden Seiten gedruckt und gebrannt werden.

Fig. 1 zeigt die Abdichtung der mit der Trägerschicht 17 allerdings noch porös verschlossenen Durchgangsöffnungen 14. Dies wird dadurch erzeugt, daß auf die eine Brücke bildende Trägerschicht 17 vorzugsweise zwei- oder mehrmals eine Dielektrikum-Dickschichtpaste als Dichtungsschicht 18 aufgetragen wird. Diese Dichtungsschicht 18 wird jeweils aufgedruckt und anschließend getrocknet und gebrannt. Hierdurch wird die über die Schichten 16 und 17 durchkontaktierte Durchgangsöffnung 14 abgedichtet. Durch Anpassung der Ausdehnungskoeffizienten der verwandten Pasten können Risse beim Abkühlen vermieden werden. Vorteilhaft können die Pasten der Type IP 9117 der Firma W.C. Heraeus als Dichtungsschicht 18 und IC 1214 als leitende Schicht 16 und Trägerschicht 17 verwandt werden.

Beim erfindungsgemäßen Verfahren ist besonders vorteilhaft, daß das hermetische Verschließen der durchkontaktierten Durchgangsöffnungen keinen zusätzlichen Flächenbedarf weder auf der einen noch auf der anderen Fläche 12 bzw. 13 des Keramiksubstrats 11 erfordert. Die anzuwendende Technik, nämlich Siebdruck- und Einbrennvorgänge sind in der Dickschichttechnik bekannt. Aufwendige Verfahren, wie z.B. Löten oder weitere Teile, wie z.B. Metallbleche sind erfindungsgemäß nicht erforderlich. Auch müssen die Durchkontaktierungen keine zusätzlichen Eigenschaften, wie z.B. Lötbarkeit, aufweisen.

Erfindungsgemäß kann ein Keramiksubstrat 11 aus einer 96 %-igen Aluminiumoxid-Keramik verwandt werden, welches mit den genannten Dickschichtpasten beschichtet wird. Die verwandten Dickschichtpasten können vorteilhaft bei 850°C eingebrannt werden. Die Durchkontaktierungen, also die leitenden Schichten 16 und die Trägerschicht 17 werden mit der bereits genannten Silberpalladium-Leiterbahnpaste erzeugt. Um eventuell vorhandene Leckstellen nur einer Dichtungsschicht 18 zu vermeiden, kann eine zweite Dichtungsschicht 18 aufgebracht werden.

Bei Dickschichtschaltungen können Überkreuzungen bzw. mehrere Schichten additiv hergestellt werden. Hierzu kann erfindungsgemäß auch das als Dichtungsschicht 18 verwandte Dielektrikum genutzt werden, wodurch also auch über verschlossene Durchkontaktierungen nicht dargestellte Leiterbahnen gedruckt werden können. Die genannten Dickschichtmaterialien sind selbstverständlich nur beispielhaft angegeben.

Die in der vorstehenden Beschreibung, in den Fig. sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Verschlossene Durchkontaktierung für ein Keramiksubstrat (11) einer Dickschichtschaltung mit einer Durchgangsöffnung (14), deren innere Mantelfläche (15) mit einer leitenden Schicht (16) versehen ist, welche mit Leiterbahnen auf beiden Flächen (12, 13) des Keramiksubstrats (11) verbunden ist und deren eine Öffnung mit einer anorganischen Schicht (17, 18) verschlossen ist,
dadurch gekennzeichnet, daß die verschließende anorganische Schicht mindestens aus einer an der leitenden Schicht (16) angrenzenden und zum Keramiksubstrat überlappenden Trägerschicht (17) und einer Dichtungsschicht (18) besteht.

2. Durchkontaktierung nach Anspruch 1,
dadurch gekennzeichnet, daß die leitende Schicht (16) auf der zweiten Fläche (13) des Keramiksubstrats (11) mit weiteren als Leiterbahnen ausgebildeten leitenden Schichten (16) bedruckt ist, und daß die andere erste Fläche (12) des Keramiksubstrats (11) im Bereich der Durchgangsöffnung (14) und dem zum Keramiksubstrat (11) überlappenden Bereich mit der Trägerschicht (17) bedruckt ist, die gleichzeitig einen Teil einer Leiterbahn darstellt.

3. Durchkontaktierung nach Anspruch 2,
dadurch gekennzeichnet, daß die Trägerschicht (17) die Durchgangsöffnung (14) überlappend mit einer Dichtungsschicht (18) leckdicht verschlossen ist.

4. Durchkontaktierung nach Anspruch 3,
dadurch gekennzeichnet, daß eine zweite Dichtungsschicht (18) aufgebracht ist.

5. Durchkontaktierung nach Anspruch 4,
dadurch gekennzeichnet, daß zwischen mehreren Dichtungsschichten (18) Leiterbahnen aufgedruckt sind.

6. Durchkontaktierung nach einem oder mehreren der vorhergehenden Ansprüche,
dadurch gekennzeichnet, daß die leitenden Schichten (16) sowie die Trägerschicht (17) aus einer Silberpalladium-Leiterbahnpaste und die Dichtungsschicht (18) aus einer Dielektrikum-Dickschichtpaste bestehen und durch Trocknen und Brennen miteinander und mit dem Keramiksubstrat (11) verbunden sind.

7. Verfahren zur Herstellung einer verschlossenen Durchkontaktierung nach einem oder mehreren der Ansprüche 1 bis 6 für ein Keramiksubstrat (11) einer Dickschichtschaltung mit einer Durchgangsöffnung (14), deren innere Mantelfläche (15) mit einer leitenden Schicht (16) versehen ist, welche mit Leiterbahnen auf beiden Flächen (12, 13) des Keramiksubstrats (11) verbunden ist und deren eine Öffnung mit einer anorganischen Schicht (17, 18) verschlossen ist,
dadurch gekennzeichnet, daß nacheinander
- in das Keramiksubstrat (11) eine Durchgangsöffnung (14) eingebracht wird,
- deren innere Mantelfäche (15) mit einer leitenden Schicht (16) bedruckt und eine oder beide Flächen (12, 13) des Keramiksubstrats (11) bedruckt werden,
- auf der zu verschließenden Fläche (12) der Durchgangsöffnung (14) eine die Ränder der Durchgangsöffnung (14) überlappende Fläche mit einer Trägerschicht (17) bedruckt und anschließend der Gegenstand getrocknet und gebrannt wird,
- wobei die bedruckte Fläche (12) des Keramiksubstrats (11) während des Trocknens und Brennens nach unten gerichtet wird, und
- zum Verschließen der Leckstellen der Trägerschicht (17) darauf mindestens eine Dichtungsschicht (18) durch Drucken, Trocknen und Brennen aufgebracht wird.

8. Verfahren nach Anspruch 7,
dadurch gekennzeichnet, daß die elektrisch leitenden Schichten (16) und die Trägerschicht (17) aus Silberpalladium-Leiterbahnpaste bestehen und gleichzeitig mit Leiterbahnen mittels Siebdrucktechnik erzeugt, getrocknet und gebrannt werden.

9. Verfahren nach Anspruch 8,
dadurch gekennzeichnet, daß die ein- oder mehrschichtig aufgebrachte Dichtungsschicht (18) aus Dielektrikumspaste besteht, mittels Siebdrucktechnik aufgebracht und getrocknet und gebrannt wird und vor jeder weiteren Schicht eine weitere Leiterbahn aufdruckbar ist.

10. Verfahren nach einem oder mehreren der vorhergehenden Ansprüche 7 bis 9,
dadurch gekennzeichnet, daß die Durchgangsöffnungen (14) in einem weniger als 1 mm dicken Keramiksubstrat (11) durch Lasertechnik erzeugt werden und einen Durchmesser von einigen Zehntelmillimetern haben, und elektrische Bauelemente und ein Lötkamm auf dem Keramiksubstrat (11) angeordnet und verlötet werden.
